# FASCICULE DE BREVET EUROPEEN

(11) **EP 0 543 742 B1**
(45) Date de publication et mention de la délivrance du brevet: **17.01.1996**
(21) Numéro de dépôt: 92420414.2
(22) Date de dépôt: 13.11.1992
(51) Int. Cl.: H01L 27/02

(54) **Diode de protection monolithique basse tension à faible capacité**
Monolithische Niederspannungsschutzdiode mit geringer Kapazität
Monolithic low-voltage protection diode with low capacity

(30) Priorité: 18.11.1991 FR 9114446
(43) Date de publication de la demande: 26.05.1993
(73) Titulaire: SGS-THOMSON MICROELECTRONICS S.A., F-94250 Gentilly (FR)
(72) Inventeur: Anceau, Christine, F-37390 Saint Roch (FR)
(74) Mandataire: de Beaumont, Michel

(56) Documents cités:
- GB-A- 2 234 126
- US-A- 4 922 371
- PATENT ABSTRACTS OF JAPAN vol. 10, no. 221 (E-424)(2277) 2 Août 1986

## Description

La présente invention concerne le domaine des diodes de protection, et plus particulièrement des diodes de protection basse tension.

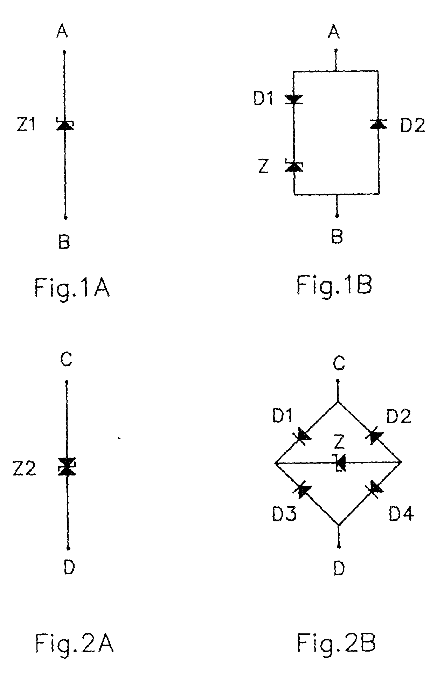

Une diode de protection unidirectionnelle Z1 (figure 1A) est un dispositif laissant passer le courant dans un sens direct (en ses bornes B et A) et bloquant le courant dans le sens inverse (entre ses bornes A et B) tant que la tension ne dépasse pas un seuil déterminé. Une diode bidirectionnelle Z2 ( figure 2A) est un dispositif laissant passer un courant entre ses bornes C et D ou D et C seulement quand la tension entre ces bornes dépasse un seuil déterminé.

Ces diodes sont prévues pour être placées en parallèle sur des circuits à protéger et n'agir que dans des cas exceptionnels de surtension. Elles ne doivent donc à l'état normal de la tension d'alimentation ou de fonctionnement du circuit n'avoir aucun rôle et ne pas perturber le circuit. Toutefois, on sait qu'une diode de protection basse tension présente une capacité entre ses bornes relativement élevée. En effet, la capacité entre les bornes d'une diode augmente proportionnellement à la surface de la jonction utile de cette diode et exponentiellement avec le dopage de la couche la moins dopée au niveau de la jonction. Or, dans le cas d'une diode de protection, si l'on veut obtenir une tension de claquage relativement faible, de l'ordre de 5 à 10 volts, le dopage de la couche la moins dopée doit être élevé (quelques 10¹⁸ atomes par cm³) et donc la capacité de la diode est inévitablement forte. Par exemple, une diode de protection basse tension ayant une tension de claquage de l'ordre de 5 volts a une capacité de l'ordre de 5000 pF/mm. Pour satisfaire à sa fonction de protection, la surface de ce type de dispositif est rarement inférieure à 0,5 mm ; ceci conduit à des capacités de 2500 pF. Cette valeur, relativement élevée, est susceptible de perturber le fonctionnement du circuit à protéger.

Pour résoudre ce problème, on a déjà proposé dans l'art antérieur d'associer aux diodes de protection de simples diodes de redressement classiques selon divers montages. Ces divers montages ont tous présenté des inconvénients et n'ont en outre pas conduit jusqu'à présent à la réalisation de composants de protection monolithiques.

Ainsi, un objet de la présente invention est de prévoir des associations de diodes de protection et de diodes classiques permettant d'obtenir un composant de protection de faible capacité.

Un objet plus particulier de la présente invention est de prévoir la réalisation sous forme de composant monolithique d'une association de diodes équivalant à une diode de protection à faible capacité.

Pour atteindre cet objet ainsi que d'autres, la présente invention prévoit une diode de protection unidirectionnelle monolithique selon la revendication 1.

La présente invention prévoit aussi une diode de protection bidirectionnelle monolithique selon la revendication 6.

D'autres modes de réalisations de la présente invention sont décrits dans les revendications dépendantes.

On notera qu'un avantage supplémentaire du composant de protection bidirectionnelle selon la présente invention est qu'il présente une faible capacité dynamique. En effet, la diode de protection incluse dans ce composant est toujours polarisée dans la même direction et donc, si la tension aux bornes du composant change de polarité, sans dépasser la tension de seuil de ce composant, la charge de ce composant reste toujours dans le même sens.

Ces objets, caractéristiques et avantages ainsi que d'autres de la présente invention seront exposés en détail dans la description suivante de modes de réalisation particuliers faite en relation avec les figures jointes parmi lesquelles :
les figures 1A et 2A représentent les symboles classiquement utilisés pour des diodes de protection uni- et bidirectionnelle ;
les figures 1B et 2B représentent des montages de diodes équivalant respectivement à une diode de protection unidirectionnelle et à une diode de protection bidirectionnelle de faible capacité ;
la figure 3 représente un mode de réalisation d'un composant de protection unidirectionnelle à faible capacité selon la présente invention ;
la figure 4 représente un mode de réalisation d'un composant de protection bidirectionnelle à faible capacité selon la présente invention ; et
les figures 5 et 6 illustrent, en vue de dessus des assemblages de diodes selon l'invention.

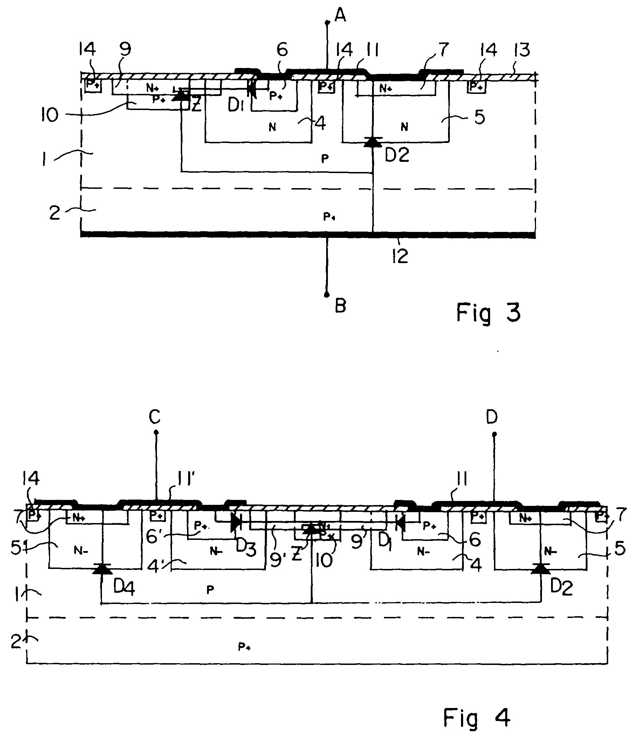

Dans les figures 3 et 4 qui présentent des vues en coupe de structures semiconductrices, on notera que, oomme cela est usuel, les épaisseurs et les étendues latérales des couches ne sont pas tracées à l'échelle pour améliorer la lisibilité des figures et la facilité de représentation. L'homme de l'art connaît les épaisseurs habituelles des couches et les étendues à leur donner en fonction des courants à faire circuler et des valeurs de capacité désirées.

La figure 1B représente un assemblage de diodes ayant la même fonction que la diode de protection (ou diode à avalanche, ou diode zener) Z1 de la figure 1A. Cet assemblage de diodes comprend, entre des bornes A et B, une diode D1 montée tête-bêche avec une diode zener Z correspondant à la diode Z1 et une diode D2 montée entre les bornes A et B et polarisée en sens inverse de la diode D1. Ainsi, quand la borne B est positive par rapport à la borne A, le courant s'écoule par la diode D2 comme il s'écoulait par la diode Z1 en direct. Quand la borne A est positive par rapport à la borne B, la diode D2 est en inverse ainsi que la diode Z. C'est seulement quand la borne A présente une tension positive supérieure à celle de la borne B d'une valeur égale à la tension d'avalanche de la diode Z augmentée de de la chute de tension en direct de la diode D1, (environ 0,6 à 0,7 volt) qu'un courant s'écoule par les diodes D1 et Z pour protéger le dispositif placé entre les bornes A et B. Cet assemblage a donc bien la même fonction que celui de la figure 1A. Toutefois, les diodes D1 et D2 étant des diodes de redressement classiques présentant une tension d'avalanche très élevée, leur capacité est très faible, par exemple de l'ordre de quelques dizaines de picofarads. La valeur de la capacité de la diode Z étant très élevée devant celle de la diode D1, la connexion en série de ces deux diodes présente une capacité sensiblement égale à celle de la diode D1 et la capacité de l'ensemble entre les bornes A et B est sensiblement égale à la somme des capacités des diodes D1 et D2. On obtient ainsi un composant de protection ayant une capacité de l'ordre de quelques dizaines de picofarads au lieu de plusieurs milliers.

La figure 2B représente un composant de protection bidirectionnelle équivalent au composant de protection Z2 de la figure 2A. Ce dispositif comprend entre des bornes C et D un pont de diodes D1 à D4 dans la diagonale duquel est insérée une diode de protection Z. Cette diode Z doit avoir une tension d'avalanche inférieure à celle de la double diode de protection Z2 d'une valeur de deux chutes de tension en direct de diode. En effet, on voit dans ce montage qu'un courant ne circule entre les bornes C et D que si la tension, dans quelque sens qu'elle soit, est supérieure à celle de l'autre borne de la tension d'avalanche de la diode Z augmentée de deux chutes de tension de diode en direct. Si la borne C est positive, le courant passe par les diodes D1, Z et D4. Si la borne D est positive, le courant passe par les diodes D3, Z et D2. On notera que dans les deux cas, la diode Z est soumise à une même direction de polarisation et donc que, quand le sens de la tension change, il n'y a pas de transfert de charges capacitives d'une borne à l'autre de cette diode et donc que ce montage ne présente pas d'effet de capacité dynamique important.

La demanderesse a découvert que les montages des figures 1B et 2B pouvaient être mis en oeuvre par des circuits semiconducteurs monolithiques de structure relativement simple.

La figure 3 représente un mode d'intégration monolithique du montage de la figure 1B.

En figure 3, on a représenté en superposition une structure semiconductrice et, à l'emplacement des jonctions jouant un rôle actif, les diodes D1, D2 et Z par leurs symboles classiques utilisés en figure 1B.

Cette structure comprend un substrat 1 de type P. De façon classique, ce substrat 1 peut être formé sur une couche de silicium 2 dopée de type P⁺ sur laquelle ce substrat 1 est obtenu par croissance épitaxiale. Dans le substrat 1 sont formés deux caissons de type N, respectivement 4 et 5. Dans le caisson 4 est formé une région 6 de type P⁺ et dans le caisson 5 une région 7 de type N⁺.

Sur le côté du caisson 4 de type N, et en contact avec celui-ci, est formée une région 9 de type N⁺ sous laquelle se trouve une région 10 de type P⁺. La région 10 se trouve sous la région N⁺ sans être en contact avec le caisson 4. Les surfaces supérieures des régions P⁺ 6 et N⁺ 7 sont reliées par une métallisation 11 qui constitue la borne A de la figure 1B. La face inférieure de la structure semiconductrice est également revêtue d'une métallisation 12 qui constitue la borne B. On a également représenté de façon classique une couche isolante 13 revêtant la surface supérieure de la structure semiconductrice aux emplacements où la métallisation 11 n'est pas en contact avec cette structure.

Les diodes D1, D2 et Z ont été figurées pour faire apparaître l'équivalence entre la structure semiconductrice et le schéma de la figure 1B. On notera que cette structure est particulièrement simple à fabriquer. En effet, les deux caissons N 4 et 5 résultent d'une même étape de dopage (diffusion ou implantation). Après quoi, sont formées les couches 6 et 10 de type P⁺, séparèrent ou simultanément, puis les régions 7 et 9 de type N⁺. Le seul dopage critique de cette structure est celui existant à l'interface entre la région P⁺ 10 et la région N⁺ 9 qui fixe la tension d'avalanche de la diode de protection.

A titre d'exemple numérique, le substrat 1 pourra avoir un niveau de dopage de l'ordre de quelques 10¹⁵ atomes par cm³. Les caissons N 4 et 5 résultent d'une diffusion telle qu'à l'interface entre la région N 4 et la région P⁺ 6, le niveau de dopage du caisson N soit de l'ordre de 10¹⁶ at./cm³. La région P⁺ 10 sera formée de sorte que son niveau de dopage à son interface avec la région N⁺ 9 soit de l'ordre de quelques 10¹⁸ at./cm³ (cette valeur étant choisie en fonction de la tension d'avalanche recherchée) et les régions N⁺ pourront classiquement avoir un dopage élevé de l'ordre de 10⁰ at./cm³.

De façon classique, on pourra prévoir de part et d'autre de chaque région de type N des zones 14 d'arrêt de canal de type P⁺.

On notera que dans cette structure peut apparaître un transistor parasite constitué de la région P⁺ 6, du caisson N 4 et du substrat 1. Divers moyens classiques pourront être utilisés pour limiter le gain de ce transistor par exemple, on pourra réduire la durée de vie des porteurs minoritaires dans la région N en réalisant un dopage à l'or ou au platine.

La figure 4 représente une réalisation sous forme de circuit monolithique du schéma de la figure 2B. On notera que la partie droite de cette structure, constituant les diodes D1, D2 et Z, correspond très exactement à la structure de la figure 3. La partie gauche de la figure 4, constituant les diodes D3, D4 et Z, où chaque élément correspondant est désigné par une même référence que dans la partie droite affectée d'un exposant prime, se déduit par symétrie de la partie droite. Dans cette réalisation, il n'y a pas de contact sur la face inférieure du substrat et ce sont les deux métallisations 11 et 11' qui constituent les bornes du composant. Etant donné cette symétrie, il est inutile de décrire plus en détail cette figure 4.

La présente invention est susceptible de nombreuses variantes et modifications qui apparaîtront à l'homme de l'art. Bien que la figure 3 représente un mode de réalisation préféré de la présente invention, on pourra également réaliser, par exemple par souci de compatibilité avec d'autres éléments formés dans le même substrat semiconducteur, une même structure en inversant tous les types de conductivité.

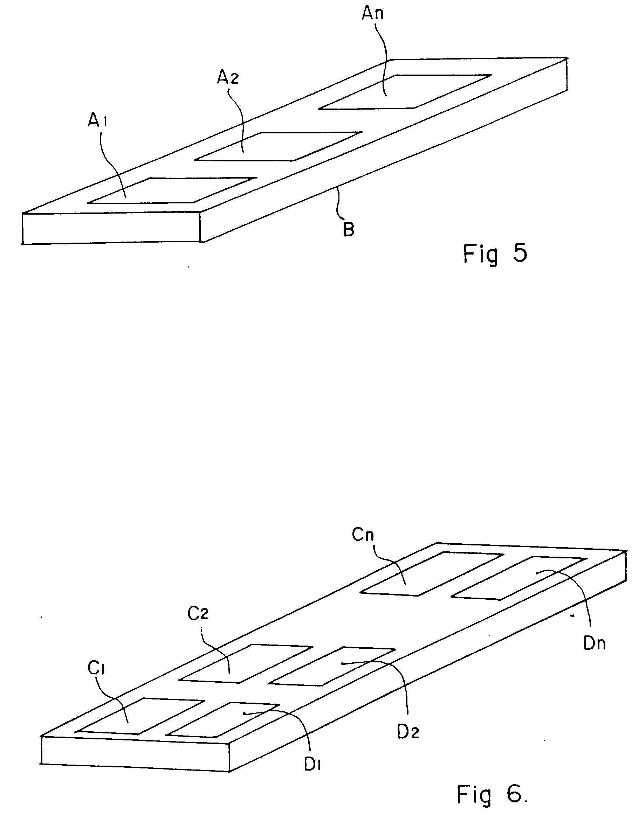

Comme le représentent schématiquement en vue en perspective les figures 5 et 6, plusieurs diodes de protection unidirectionnelles avec plusieurs électrodes A₁, A₂ ... An (figure 5) ou plusieurs diodes de protection bidirectionnelles (figure 6) avec plusieurs électrodes C₁, C₂ ... Cₙ et D₁, D₂ ... Dₙ peuvent être disposées sur un même substrat.

## Revendications

1. Diode de protection unidirectionnelle monolithique formée dans un substrat semiconducteur (1) d'un premier type de conductivité à faible niveau de dopage, comprenant, du côté de la face supérieure du substrat :
un premier et un deuxième caisson (4, 5), situés côte à côte et sans se contacter, du deuxième type de conductivité à niveau de dopage moyen ;
à la surface supérieure du premier caisson (4), une première région (6) du premier type de conductivité à niveau de dopage élevé située dans le premier caisson (4) ;
à la surface supérieure du deuxième caisson (5), une deuxième région (7) du deuxième type de conductivité à niveau de dopage très élevé située dans le deuxième caisson (5) ;
une troisième région (9) du deuxième type de conductivité à niveau de dopage très élevé à côté du et en contact avec le premier caisson (4) ;
une quatrième région (10) du premier type de conductivité à niveau de dopage élevé sous et en contact avec la surface inférieure de la troisième région (9) ;
une première métallisation (11), en contact avec la surface des première (6) et deuxième (7) régions, constituant la première borne de la diode ; et
une deuxième métallisation (12) liée à une zone du substrat (1) d'un premier type de conductivité s'étendant jusqu'à la quatrième région (10) et au deuxième caisson (5), constituant la deuxième borne de la diode.

2. Diode de protection unidirectionnelle monolithique selon la revendication 1, caractérisée en ce que la face inférieure du substrat comprend une couche surdopée du premier type de conductivité (2) et en ce que la deuxième métallisation (12) est en contact avec cette face inférieure.

3. Diode de protection unidirectionnelle monolithique selon la revendication 1, caractérisée en ce que le premier type de conductivité est le type P.

4. Diode de protection unidirectionnelle monolithique selon la revendication 1, caractérisée en ce que les deuxième (7) et troisième (9) régions sont également dopées.

5. Diode de protection unidirectionnelle monolithique selon la revendication 3, caractérisée en ce que les première (6) et quatrième (10) régions sont également dopées.

6. Diode de protection bidirectionnelle monolithique, caractérisée en ce qu'elle est constituée de deux diodes de protection unidirectionnelles monolithiques selon la revendication 1 sans lesdites deuxièmes métallisations (12), disposées symétriquement par rapport aux troisième (9) et quatrième (10) régions qui sont communes à ces deux diodes, et en ce qu'elle comprend deux métallisations qui correspondent aux premières métallisations symétrisées.

7. Diode de protection selon l'une quelconque des revendications 1 à 6, caractérisée en ce que les parties profondes des premier et deuxième caissons comprennent des moyens pour y réduire la durée de vie des porteurs minoritaires.

8. Diode de protection selon la revendication 7, caractérisée en ce que lesdits moyens résultent d'une diffusion d'or ou de platine.

## Patentansprüche

1. Monolithische unidirektionale Schutzdiode, welche aus einem Halbleitersubstrat (1) eines ersten Leitfähigkeittyps mit einem niedrigen Dotierungspegel hergestellt ist, mit folgenden Merkmalen auf der Seite der Oberseite des Substrats:
- einer ersten und einer zweiten Senke (4, 5) des zweiten Leitfähigkeitstyps mit einem mittleren Dotierungspegel, welche ohne sich zu berühren Seite an Seite angeordnet sind,
- einen ersten Bereich (6) des ersten Leitfähigkeitstyps mit einem hohen Dotierungspegel an der Oberseite der ersten Senke, welcher in der ersten Senke (4) angeordnet ist,
- einen zweiten Bereich (7) des zweiten Leitfähigkeitstyps mit einem sehr hohen Dotierungspegel an der Oberseite der zweiten Senke (5), welcher in der zweiten Senke (5) angeordnet ist,
- einen dritten Bereich (9) des zweiten Leitfähigkeitstyps mit sehr hohem Dotierungspegel an der Seite der und in Kontakt mit der ersten Senke (4),
- einen vierten Bereich (10) des ersten Leitfähigkeitstyps mit einem hohen Dotierungspegel unter und in Kontakt mit der Unterseite des dritten Bereiches (9),
- eine erste Metallisierung (11) in Kontakt mit der Oberfläche des ersten (6) und des zweiten (7) Bereiches, welche den ersten Anschluß der Diode bildet, und
- eine zweite Metallsierung (12), die mit einem Bereich des Substrats (1) des ersten Leitfähigkeitstyps verbunden ist, welcher sich bis zu dem vierten Bereich (10) und zu der zweiten Senke (5) erstreckt, welche den zweiten Anschluß der Diode bildet.

2. Monolithische unidirektionale Schutzdiode nach Anspruch 1, dadurch **gekennzeichnet,** daß die Unterseite des Substrats eine überdotierte Schicht des ersten Leitfähigkeitstyps (2) aufweist und daß die zweite Metallisierung (12) in Kontakt mit dieser Unterseite ist.

3. Monolithische unidirektionale Schutzdiode nach Anspruch 1, dadurch **gekennzeichnet,** daß der erste Leitfähigkeitstyp der P-Typ ist.

4. Monolithische unidirektionale Schutzdiode nach Anspruch 1, dadurch **gekennzeichnet,** daß der zweite (7) und der dritte (9) Bereich gleich dotiert sind.

5. Monolithische unidirektionale Schutzdiode nach Anspruch 3, dadurch **gekennzeichnet,** daß der erste (6) und der vierte (10) Bereich gleich dotiert sind.

6. Monolithische bidirektionale Schutzdiode, dadurch **gekennzeichnet,** daß sie aus zwei monolithischen unidirektionale Schutzdioden gemäß Anspruch 1 aufgebaut ist, welche ohne die zweiten Metallisierungen (12) hinsichtlich des dritten (9) und des vierten (10) Bereiches symmetrisch angeordnet sind, wobei diese Bereich beiden Dioden gemeinsam sind, und daß sie zwei symmetrische Metallisierungen aufweist, welche der ersten Metallisierung entsprechen.

7. Schutzdiode nach einem der Ansprüche 1 bis 6, dadurch **gekennzeichnet,** daß die tiefen Teile der ersten und der zweiten Senke Mittel zum Vermindern der Lebensdauer der Minoritätsträger aufweisen.

8. Schutzdiode nach Anspruch 7, dadurch **gekennzeichnet,** daß sich diese Mittel aus einer Diffusion von Gold oder Platin ergeben.

## Claims

1. A monolithic unidirectional protection diode, formed in a low doped semiconductor substrate (1) of a first conductivity type comprising, in an upper surface of the substrate:
- a first and a second well (4, 5), arranged side by side and without contact, of the second conductivity type with a mean doping level;
- at the upper surface of the first well (4), a first highly doped region (6) of the first conductivity type, formed in the first well (4);
- at the upper surface of the second well (5), a second very highly doped region (7) of the second conductivity type, formed in the second well (5);
- a third very highly doped region (9) of the second conductivity type, laterally contacting the first well (4);
- a fourth highly doped region (10) of the first conductivity type beneath a portion of the lower surface of the third region (9) and in contact therewith;
- a first metallization (11) contacting the surface of the first (6) and second (7) regions constituting the first terminal of the diode; and
- a second metallization (12) coupled to an area of the substrate (1) of the first conductivity type extending up to said fourth region (10) and to said second well (5), constituting the second terminal of the diode.

2. A monolithic unidirectional protection diode according to claim 1, characterized in that the lower surface of the substrate comprises an overdoped layer of the first conductivity type (2) and said second metallization (12) contacts said lower surface.

3. A monolithic unidirectional protection diode according to claim 1, characterized in that said first conductivity type is P-type.

4. A monolithic unidirectional protection diode according to claim 1, characterized in that said second (7) and third (9) regions are equally doped.

5. A monolithic unidirectional protection diode according to claim 3, characterized in that said first (6) and fourth (10) regions are equally doped.

6. A monolithic bidirectional protection diode characterized in that it combines two monolithic unidirectional protection diodes according to claim 1, without said second metallizations (12) arranged symmetrically with respect to the third (9) and fourth (10) regions that are common to both diodes, and in that it comprises two symmetrical metallizations which correspond to said first metallization.

7. A protection diode according to any of claims 1 to 6, characterized in that the deep portions of the first and second wells comprise means for reducing the lifetime of the minority carriers.

8. A protection diode according to claim 7, characterized in that said means result from gold or platinum diffusion.
